Europäisches Patentamt

(19) European Patent Office

Office européen des brevets

(11) Publication number : **0 323 836 B1**

# EUROPEAN PATENT SPECIFICATION

(45) Date of publication of patent specification :
**14.09.94 Bulletin 94/37**

(51) Int. Cl.[5] : **G03F 7/26**

(21) Application number : **89100093.7**

(22) Date of filing : **04.01.89**

(54) **Method for manufacturing lithographic printing plates.**

(30) Priority : **07.01.88 JP 1701/88**

(43) Date of publication of application :
**12.07.89 Bulletin 89/28**

(45) Publication of the grant of the patent :
**14.09.94 Bulletin 94/37**

(84) Designated Contracting States :
**DE GB**

(56) References cited :
**EP-A- 0 129 106**
**EP-A- 0 178 495**
**FR-A- 2 172 914**
**GB-A- 1 102 952**
**US-A- 2 318 322**
**US-A- 3 608 464**

(56) References cited :
**RESEARCH DISCLOSURE, vol. 177, no. 116, December 1973, pages 101-103, no. 11664, Havant, GB; "Novel composition for the stripping of photosensitive surfaces usable in the preparation of photographic resists"**

(73) Proprietor : **Fuji Photo Film Co., Ltd.**
**210 Nakanuma**
**Minamiashigara-shi**
**Kanagawa-ken (JP)**

(72) Inventor : **Toyama, Tadao c/o Fuji Photo Film Co., Ltd.**
**4000, Kawashiri**
**Yoshida-cho**
**Haibara-gun Shizuoka-ken (JP)**

(74) Representative : **Patentanwälte Grünecker, Kinkeldey, Stockmair & Partner**
**Maximilianstrasse 58**
**D-80538 München (DE)**

## Description

The present invention relates to a method for preparing a lithographic printing plate wherein a constant amount of fresh developer is constantly supplied to be able to perform stable development processing and which can suitably be applied to a "disposable development system".

When large amounts of presensitized plates for preparing lithographic printing plates (hereinafter referred to as "PS plate(s)") are developed, an automatic developing machine is in general used.

Such an automatic developing machine comprises a device for horizontally conveying a PS plate, a bath which contains a developer and a spray device. In such a developing machine, a method comprising spraying the developer pumped up onto the PS plate, which has been exposed to light, through a spray nozzle to develop the same while horizontally conveying the exposed PS plates is generally adopted. Alternatively, it is also known to develop such a PS plate by immersing and conveying the plate in the developer by means of, for instance, dipped guide rolls.

In such a processing in which an automatic developing machine is used, the developer is repeatedly used from the viewpoint of economy. As a result, various problems arise, for instance, the concentrations of components of the light-sensitive layer dissolved in the developer gradually increase, correspondingly the developing ability of the developer is deteriorated and feculence and sludge are formed in the developer. Moreover, if the developer is an alkali solution, it absorbs carbon dioxide in the air to cause deterioration.

In addition to the foregoing deterioration of the developer, the automatic developing machine is contaminated with spatter of sprayed developer. Therefore, it is required to frequently exchange the developer and wash the automatic developing machine.

When a large number of PS plates is processed in accordance with a method in which a circulated developer is used in order to eliminate these disadvantages, a method for supplementing a replenisher as disclosed in JP-A-55-115039 and JP-A-58-95349 may be used. This method makes it possible to perform stable processing for a long period of time. However, this method also has problems in that complicated handlings such as fine adjustments and set up are required.

As a means for eliminating the drawbacks accompanied by the method for processing PS plates utilizing an automatic developing machine while circulating a large amount of developer to reuse the same, JP-A-48-29505 and JP-A-55-32044 and US-A-4,222,656 disclose a method which comprises supplying a constant amount of a fresh developer onto the surface of a PS plate which has been exposed to light to develop the plate and then removing the developer from the plate to dispose the used developer (this method is hereinafter referred to as "disposable developing system").

In this disposable developing system, it should be necessary to uniformly hold, on a PS plate, the smallest required amount of a developer for a constant time period. However, the developer is likely to be non-uniformly distributed thereon and hence uneven development is often caused. This is particularly true at the edge portion and in the cases where the substrate of the PS plate has uneven portions. To solve this problem, various steps such as supplementation of a large amount of a developer and use of a brush or a sponge to uniformly distribute the developer have been taken. However, these steps require the use of the developer in an amount greater than the smallest required amount thereof and this is not preferred in view of the running costs.

A more severe problem of the disposable developing system is that double side type PS plates having light-sensitive layers on both sides cannot be processed simultaneously. In other words, if the double side type PS plates are developed by the disposable developing system, it is necessary to uniformly hold the required amount of a developer even on the back side of the plate, which is conveyed horizontally, for a constant time period, but the developer cannot be maintained thereon but is dropped or concentrated at the lower portions. Thus, a uniform development of the whole surface is impossible. For this reason, both sides are separately processed one by one when such a double side type PS plate is developed by the disposable developing system. However, uneven development is often observed because the developer passes around behind the back surface.

In order to eliminate the aforementioned drawbacks, it has been thought to vertically convey the double side type PS plate while supplying a developer to both sides thereof. The developer runs down from the surface of the plate, but is not held thereon uniformly which leads to uneven development.

It is the object of the present invention to provide a method for preparing lithographic printing plates which can stably process both sides of double side type PS plates simultaneously and which can provide uniform finishing although a small amount of developer is used.

Said object is achieved by a method for preparing a lithographic printing plate which comprises:

(a) developing an imagewise light-exposed presensitized plate comprising a metal substrate having light-sensitive layers on both surfaces of the substrate, by simultaneously applying a fresh aqueous alkaline developer to each surface of the imagewise exposed light-sensitive layer while horizontally conveying the presensitized plate, maintaining the applied developer in a time period sufficient to remove either the light-exposed or the light-unexposed areas of the light-sensitized layer, and
(b) removing the applied developer, and disposing the removed developer which is not reused, wherein the developer applied to both surfaces of the light-sensitive layers has a viscosity in the range of from 0,005 to 10 Pa.s (5 to 10,000 cps) at 25°C.
The present invention will hereinafter be explained in more detail.

I. Developer

The developer used in the present invention will be detailed below.

(i) Viscosity

The viscosity of the developer used in the invention ranges from 0,005 to 10 Pa.s (5 to 10,000 cps) preferably 0,05 to 5 Pa.s (50 to 5,000 cps). If the viscosity is less than the lower limit, it is not possible to uniformly distribute the developer on the surface of the PS plate, while if it exceeds the upper limit, the circulation of the developer and the supplementation thereof on the surface of the plate are hindered.

(ii) Thickener

The developer for PS plates used in the invention usually comprises a surfactant, an organic solvent, an alkaline agent and inorganic salts. The developer used herein further comprises a thickener for adjusting the viscosity thereof.
Any thickener may be used in the developer as far as it can adjust the viscosity within a desired range. Preferred are those which can increase the viscosity of the developer by adding it only in a small amount and which exert no adverse influence on the developing ability of the developer. As such thickeners, there may be used a variety of water-soluble polymeric compounds or fine powder of silicates. Preferred are natural or synthetic water-soluble polymers.
Examples of natural polymers are starches such as sweet potato starch, potato starch, tapioca starch, wheat starch and corn starch; polymers obtained from seaweeds such as carrageenan, laminaran, seaweed mannan, funorin, Irish moss, agar and sodium alginate; plant mucin such as tororo-aoi mucin, mannan, quince seed gum pectin, tragacanth gum, karaya gum, guar bean gum, locust bean gum, arabic gum. carob gum and benzoin gum; microorganism mucins such as homopolysaccharides (e.g., dextran, glucan and levan) and heteropolysaccharides (e.g., succinoglucan and xanthan gum); and proteins such as glue, gelatin, casein and collagen.
Examples of seminatural (semisynthetic) water-soluble polymers include, in addition to propylene glycol alginate, fibrin derivatives such as viscose, methyl cellulose, ethyl cellulose, methyl ethyl cellulose, hydroxyethyl cellulose, carboxymethyl cellulose, hydroxypropyl cellulose, hydroxypropyl methyl cellulose, hydroxypropyl ethyl cellulose and hydroxypropyl methyl cellulose and processed starches. Examples of the processed starches include roasted starches such as white dextrin, yellow dextrin and British gum; enzyme modified dextrins such as enzyme dextrin and Shardinger enzyme dextrin; acid decomposed starches such as soluble starch; oxidized starches such as dialdehyde starch; alpha starches such as modified alpha starch and non-modified alpha starch; esterified starches such as phosphate starch, fatty acid starch, sulfate starch, nitrate starch, xanthogenic acid starch and carbamic acid starch; etherified starches such as carboxyalkyl starch, hydroxyalkyl starch, sulfoalkyl starch, cyanoethyl starch, allyl starch, benzyl starch, carbamyl starch and dialkylamino starch; cross-linked starches such as methylol cross-linked starch, hydroxyalkyl cross-linked starch, phosphoric acid cross-linked starch and dicarboxylic acid crosslinked starch; and starch grafted copolymers such as starch polyacrylamide copolymer, starch polyacrylic acid copolymer, starch polyvinyl acetate copolymer, starch polyacrylonitrile copolymer, cationic starch polyacrylate copolymer, cationic starch vinyl polymer copolymer, starch polystyrene maleic acid copolymer and starch polyethylene oxide copolymer.
Examples of the synthetic water-soluble polymers are polyvinyl alcohol, modified polyvinyl alcohols such as polyvinyl alcohol partially modified with acetal, allyl modified polyvinyl alcohol, polyvinyl methyl ether, polyvinyl ethyl ether and polyvinyl isobutyl ether; polyacrylic acid derivatives and polymethacrylic acid derivatives such as sodium polyacrylate, partially saponified polyacrylate, partially saponified polyacrylate copolymer, polymethacrylic acid salts and polyacrylamide; polyethylene glycol, polyvinylpyrrolidone, copolymer of polyvinyl pyrrolidone and vinyl acetate, carboxyvinyl polymer, styrene-maleic anhydride copolymer, styrene-crotonic acid coplymer, polystyrene sulfonic acid salts and polymer of 2-acrylamido-2-methylpropane sulfonic acid, copolymers thereof with other monomers or salts thereof. Among these, semisynthetic and synthetic polymers are preferred because they can impart a long term stability to the developer. These water-soluble polymeric compounds may be used alone or in combination. These water-soluble polymeric compounds are preferably used in an amount required for achieving a desired viscosity of the developer and the practical amount thereof varies depending on the molecular weight of the polymeric compounds used and the solubility thereof in water. Therefore, the amount of the water-soluble polymers cannot be defined uniquely, but it preferably ranges from 0.5 to 20% by weight based on the total weight of the developer.

(iii) Composition of the Developer

The composition of the developer may vary depending on the kinds of the PS plates to be processed. Typical examples thereof for developing, for instance, a negative working PS plate mainly composed of p-diazodiphenylamine include those composed of benzyl alcohol, an anionic surfactant and a water-soluble sulfite as disclosed in JP-A- 56-42860. The developer used in the invention further comprises the aforesaid thickener in addition to the foregoing components.

When o-quinonediazide type PS plates are processed, the composition of the developer is not restricted to a specific one as far as it is alkaline, but it is preferred to adjust the pH to not less than about 10.5 at 25 ° C taking into consideration factors such as processing time and complete dissolution or removal of the exposed portions.

a) Alkaline Agent

Examples of useful alkaline agents are an alkaline inorganic agent such as sodium silicate, potassium silicate, ammonium silicate, sodium hydroxide, lithium hydroxide, potassium hydroxide, trisodium phosphate, disodium hydrogen phosphate, tripotassium phosphate, dipotassium hydrogen phosphate, triammonium phosphate, diammonium hydrogen phosphate, sodium metasilicate, sodium bicarbonate, sodium carbonate, potassium carbonate or ammonium carbonate; an organic alkaline agent such as mono-, di- or tri-ethanolamine or ammonium tetraalkyl hydroxide; and ammonium organosilicate.

Most preferred are silicates, The amount used generally ranges from about 0.5 to about 10% by weight, preferably 1 to 8% by weight and more preferably 1 to 6% by weight on the basis of the total weight of the developer.

The silicates are represented by the formula: $SiO_2 \cdot MO_2$ (wherein M is an alkali metal). As the molar ratio: $SiO_2/MO_2$ becomes small, the development processing proceeds more rapidly. In particular in the method for manufacturing lithographic printing plates of the invention wherein operations for promoting development such as rubbing with a brush or a sponge are not performed or only a simple development promoting operation is carried out, the molar ratio is preferably not more than 1.2. In addition, if a water-soluble polymeric compound is used as a thickener, it sometimes consumes alkali. In such a case, it is preferred to supplement alkaline agents.

b) Surfactant

Moreover, the developer for PS plates having an o-quinonediazide type light-sensitive layer may contain as surfactants anionic or amphoteric surfactants such as sodium alkylnaphthalene sulfonate and N-tetradecyl-N,N-dihydroxyethyl betaine as disclosed in JP-A- 50-51324 and nonionic surfactants such as tetramethyldecyne diol as disclosed in US-A- 4,374,920, in order to protect the image portions and to thus prevent excess development.

It is also preferable to add a surfactant to such a kind of developer for enhancing the wettability of the PS plate. Examples of such surfactants are anionic surfactants such as sodium alkyl diphenyl ether disulfonates and sodium alkyl sulfonates, but particularly preferred are fluorine type surfactants having perfluoroalkyl groups in the molecule.

As such fluorine type surfactants, there may be mentioned an anionic type one such as perfluoroalkylcarboxylic acid salts, perfluoroalkylsulfonic acid salts or perfluoroalkyl phosphoric acid salts; an amphoteric type one such as perfluoroalkyl betaine; a cationic one such as perfluoroalkyl trimethylammonium salts; and a nonionic type one such as perfluoroalkylamine oxides, perfluoroalkyl ethylene oxide adducts, oligomers containing perfluoroalkyl groups and hydrophilic groups, oligomers having perfluoroalkyl groups and oleophilic groups, oligomers having perfluoroalkyl, hydrophilic and oleophilic groups or urethanes having perfluoroalkyl groups and oleophilic groups. These surfactants are desirably used in an amount required for reducing the surface tension of the developer to a desired level, but the amount thereof is preferably 0.001 to 3% by weight and more preferably 0.003 to 0.5% by weight on the basis of the total weight of the developer.

The developer used in the present invention may further contain various other surfactants such as those described in US-A- 374,920 and JP-A- 50-51324 already cited above in addition to the foregoing surfactants.

c) Other Additives

The developer used in the invention may comprise the following additives for the purpose of enhancing the developing quality. Examples of such additives include neutral salts such as NaCl, KCl and KBr as disclosed in JP-A- 58-75152; chelating agents such as EDTA and NTA as disclosed in JP-A- 58-190952; complexes such as $(Co(NH_3)_6)Cl_3$ and $CoCl_2 \cdot 6H_2O$ as disclosed in JP-A- 59- 121336; cationic polymers such as methyl chloride quaternary product of p-dimethylaminomethyl polystyrene as disclosed in JP-A- 55-95946; amphoteric polyelectrolytes such as copolymer of vinylbenzyl trimethyl ammonium chloride and sodium acrylate as disclosed in JP-A- 56-142528; reducing inorganic salts such as sodium sulfite as disclosed in JP-A- 57-192952; inorganic lithium compounds such as lithium chloride as disclosed in JP-A- 58-59444; organolithium compounds such as lithium benzoate as disclosed in JP-A- 50-34442; organometallic surfactants containing Si and Ti as disclosed in JP-A- 59-75255; organoboron compounds as disclosed in JP-A- 59-84241; quaternary ammonium salts such as tetraalkyl ammonium oxide as disclosed in EP-B-101,010; and organic solvents such as benzyl alcohol and ethylene glycol monophenyl ether.

II. PS Plates

The PS plates processed by the method of this invention are not restricted to specific ones and typical examples thereof include those composed of an aluminum plate provided thereon with a light-sensitive layer consisting of a mixture of a diazo resin (a salt of a condensed product of p-diazodiphenylamine and paraformaldehyde) and shellac as disclosed in GB-A- 1,350,521; negative working PS plates composed of an aluminum plate provided thereon with a light-sensitive layer consisting of a mixture of a diazo resin and a polymer which comprises hydroxyethyl methacrylate units and hydroxyethyl acrylate units as main repeating units as disclosed in GB-A-1,460,978 and GB-A- 1,505,739; positive working PS plates composed of an aluminum plate provided thereon with a light-sensitive layer consisting of an o-quinonediazide compound; and negative working PS plates comprising a light-sensitive layer consisting essentially of an o-quinonediazide compound as disclosed in JP-A- 56-14970, which show the negative working effect after imagewise exposing, heating, exposing the whole surface thereof to light and development processing. Besides, negative working PS plates having a photopolymerizable light-sensitive layer or a photocross-linkable light-sensitive layer can likewise be treated by the method of the present invention.

The method for manufacturing lithographic printing plates according to the present invention will be detailed below referring to a PS plate composed of a substrate provided thereon with a light-sensitive layer which comprises an o-quinonediazide compound, particularly an o-naphthoquinonediazide compound as an example.

(i) Substrate

Examples of preferred substrates are metal plates such as aluminum (inclusive of aluminum alloys), zinc, tin, copper and iron plates and composite plates thereof; plastic films or sheets such as cellulose diacetate, cellulose triacetate, cellulose propionate, cellulose butyrate, cellulose acetate butyrate, cellulose nitrate, polyethylene terephthalate, polyethylene, polypropylene, polystyrene, polycarbonate and polyvinyl acetal films or sheets; paper or a plastic film on which the foregoing metal is deposited or with which a film of the foregoing metal is laminated; and composite sheets such as that obtained by bonding a polyethylene terephthalate film and an aluminum sheet. Particularly preferred are those having an aluminum surface because of their high dimensional stability.

The surface of these substrates is in general subjected to surface processing for the purposes of making it hydrophilic, preventing a harmful reaction with the light-sensitive layer subsequently provided thereon and enhancing the adhesion between the substrate and the light-sensitive layer. For instance, a substrate having an aluminum surface is preferably grained mechanically, chemically or electrically and then dipped in an aqueous solution of, for instance, sodium silicate, potassium fluorozirconate or a phosphate, or subjected to an anodization treatment. In this respect, the anodization treatment can be performed by electrolyzing by passing an electric current through an aluminum plate serving as an anode in an electrolyte comprised of an aqueous solution containing one or more inorganic salts of inorganic acids such as sulfuric acid, chromic acid, phosphoric acid and boric acid; organic acids such as oxalic acid and sulfamic acid and salts thereof. The use of silicate electrodeposition as disclosed in US-A-3,658,662 is also effective in the invention.

Specific examples of such substrates are an aluminum plate which is grained and is then dipped in a solution of sodium silicate as disclosed in US-A- 2,714,066; an aluminum plate which is anodized and is then dipped in a solution of an alkali metal silicate as disclosed in JP-A- 47-5125; and a substrate which is electrolytically grained and then anodized as disclosed in JP-A- 46-27481, JP-A-52-58602 and JP-A-52-30503.

(ii) Light-sensitive Layer

The light-sensitive layer which is provided on the substrate is preferably obtained from o-naphthoquinonediazide compounds as already mentioned above and examples thereof are described in a variety of publications such as US-A- 3,041,110; 3,046,111; 3,046,112; 3,046,115; 3,046,118; 3,046,119; 3,046,120; 3,046,121; 3,046,122; 3,046,123, 3,061,430; 3,162,809; 3,106,465; 3,635,709; and 3,647,443. All these can effectively be used in the method of the invention. Particularly preferred are o-naphthoquinone-diazido-sulfonic acid esters or o-naphthoquinonediazido-carboxylic acid esters of aromatic hydroxyl compounds and o-naphthoquinonediazido-sulfonic acid amides or o-naphthoquinonediazido-carboxylic acid amides of aromatic amine compounds. In particular, a condensed product of pyrogallol and acetone which is esterified with o-naphthoquinonediazido o-sulfonic acid as disclosed in US-A- 3,635,709; a polyester having a hydroxyl group at the terminal which is esterified with o-naphthoquinonediazido-sulfonic acid or o-naphthoquinonediazido-carboxylic acid as disclosed in US-A-4,028,111; a homopolymer of p-hydroxystyrene or a copolymer thereof with another copolymerizable monomer which is esterified with o-naphthoquinonediazi do-sulfonic acid or o-naphthoquinonediazido-carboxylic acid as disclosed in GB-A- 1,494,043.

These o-naphthoquinonediazide compounds may be used alone, but it is preferred to use same in combination with an alkali-soluble resin. Examples thereof include novolak type phenol resins, more specifically a phenol-formaldehyde resin, an o-cresol/formaldehyde resin and a m-cresol/formaldehyde resin. It is more preferable to simultaneously use a condensate of a phenol or cresol substituted with alkyl groups having 3 to 8 carbon atoms and formaldehyde such as a 1-butyl-phenol/formaldehyde resin, in addition to the foregoing phenol resin, as disclosed in JP-A- 50-125806. The amount of these alkalisoluble resins used ranges from about 50 to about 85% by weight, preferably 60 to 80% by weight on the basis of the total weight of the light-sensitive layer.

The light-sensitive layer further comprises dyes, plasticizers, components for imparting print-out properties to the layer according to need. As such additives, any conventionally known ones can be used. Preferred examples of dyes are those soluble in alcohols such as C.I. 26, 105 (Oil Red RR), C.I. 21, 260 (Oil Scarlet #308), C.I. 74, 350 (Oil Blue), C.I. 52, 015 (Methylene Blue), C.I. 42, 555 (Crystal Violet), which serve to impart sufficient contrast between image areas and non-image areas of a PS plate after exposure and development. These dyes are used in an amount of not more than about 7% by weight of the total weight of the light-sensitive composition.

Examples of effective plasticizers include phthalates such as dimethyl phthalate, diethyl phthalate, dibutyl phthalate, diisobutyl phthalate, dioctyl phthalate, octyl capryl phthalate, dicyclohexyl phthalate, ditridecyl phthalate, butyl benzyl phthalate, diisodecyl phthalate and diaryl phthalate; glycol esters such as dimethyl glycol phthalate, ethylphthalyl ethyl glycolate, methylphthalyl ethyl glycolate, butylphthalyl butyl glycolate and triethylene glycol dicaprylate; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate; polyglycidyl methacrylate, triethyl citrate, glycerin triacetyl ester and butyl laurate. These plasticizers are in general used in an amount of not more than about 5% by weight of the total weight of the light-sensitive composition.

The components having print out properties are agents or compositions for obtaining a visible image immediately after imagewise exposure of the light-sensitive layer of a PS plate. Examples thereof are a pH indicator such as those described in GB-A- 1,041,463; a combination of o-naphthoquinonediazido-4-sulfonyl chloride and a dye as disclosed in US-A- 3,969,118; and photochromic compounds as disclosed in JP-A- 44-6413. Alternatively, it is also possible to improve the sensitivity of the light-sensitive layer by adding massive acid anhydride to the layer as disclosed in JP-A- 52-80022.

A desired light-sensitive layer can be obtained by applying a solution of the foregoing light-sensitive composition in a proper solvent onto the surface of a substrate. As solvents preferably used there may be mentioned glycol ethers such as ethylene glycol monomethyl ether, ethylene glycol monoethyl ether, methoxyethyl acetate; ketones such as acetone, methyl ethyl ketone and cyclohexanone; and chlorinated hydrocarbons such as ethylene dichloride. The coated amount of the light-sensitive composition generally ranges from about 0.5 to about 7 g/m$^2$, and preferably 1.0 to 3 g/m$^2$.

III. Development Processing

The positive working PS plate is exposed through a transparency to light from a light source rich in actinic rays such as a carbon arc lamp, a mercury lamp, a metal halide lamp, a xenon lamp or a tungsten lamp. The exposed areas thereof are made alkaline-soluble by such an exposure and, therefore, the exposed areas can be dissolved out with a developer, i.e., an alkali solution.

In the method of this invention, the supply of the developer onto the exposed PS plate can be performed by injecting, spraying or dropwise adding the developer to the surface of the plate utilizing a shower pipe or a nozzle; or by coating the surface of the plate with the developer supplied from a developer supply member which- is disposed so as to optionally come into contact with the surface thereof.

In order to supply the developer to a PS plate with a developer supply member which comes into contact with the surface of the plate, a method comprising rubbing the surface of the plate with a member having water absorption properties such as a sponge or cloth; a method comprising synchronizing the speed of the conveyed PS plate and that of a roller made from a non-water absorbing member such as a rubber or a member having water absorption properties such as the aforesaid sponge or cloth; or a method comprising dispensing the developer with a wire bar can be employed.

On the other hand, when the developer is supplied to the PS plate by a developer supply member which is disposed so as not to come into contact with the surface of the plate, a method comprising passing the PS plate through a fine gap in which the developer is stored; a method comprising bringing the surface of the plate into contact with the developer which is supplied in the form of a drop suspended from the developer supply member due to surface tension; or a method comprising passing through a slit formed on the side of a cylindrical container for the developer can be adopted. Alternatively, a method comprising flowing out the developer from a fine slit formed on the upper face of a cylindrical container for the developer while horizontally conveying the PS plate over the upper face thereof to supply the developer is very favorable for treating the back surface of the double side type PS plates. When such a double side type PS plate is developed, two sides may be developed by the same or different developer supply members. Likewise, both sides may be developed with the same or different developers. The method of the present invention can preferably be adopted even when a positive working PS plate and a negative working PS plate are processed with the same developer.

Moreover, the method of this invention is favorably adopted when the PS plates are vertically arranged and conveyed upward or downward. or towards right or left since the developer can be easily maintained on the surfaces thereof.

The amount of the developer supplied by such methods ranges from 30 to 500 ml and preferably 50 to 200 ml per 1 $m^2$ of the processed PS plate.

In the method of the invention, the disposable developing system is preferably adopted. Therefore, it is desirable that the developer supplied to the surface of the PS plate be scraped off to dispose the same after maintaining it on the surface of the plate for a constant time period.

The PS plates thus developed are subsequently subjected to conventional processes such as water washing, retouching and gumming processes to complete the lithographic printing plates, as in the conventional processing of the PS plates.

The method of this invention makes it possible to uniformly hold a small amount of a developer on both faces of a PS plate, in the disposable developing system and, therefore, it becomes possible to perform the development processing in which even the back face of the PS plate is uniformly developed. In addition, the method of the invention also makes it possible to perform uniform development using only a small amount of a developer, or ultimately an amount just required for development. Moreover, once the developer is uniformly supplied to the surface of the PS plate, the method of the present invention makes it possible to uniformly maintain the developer on the plate without using a complicated device or with using a simple device and, therefore, maintenance of the device is very easy and the development processing can be stably carried out without any troubles even when the automatic developing machine is operated over a long time.

The present invention will hereunder be described with reference to the following Examples in more detail. The effects practically achieved by the invention will also be discussed in comparison with Comparative Examples.

Examples 1 to 6 and Comparative Example 1

A grained 2S aluminum plate was immersed, for one minute, in a solution of sodium hydroxide having a concentration of 2% by weight maintained at 40 ° C to carry out etching of the aluminum plate. After washing the etched plate, the plate was immersed in a sulfuric acid/chromic acid mixture for one minute to expose the pure aluminum surface thereof. Then the plate was immersed in 20% by weight of sulfuric acid maintained at 30 ° C to carry out anodization at a DC voltage of 1.5 V and a current density of 2 A/dm$^2$ for two minutes followed by washing with water and drying. PS plates were prepared by applying a solution of a light-sensitive composition having the following composition onto the aluminum plate thus treated in an amount of 2 g/m$^2$ (weighed after drying) and then drying.

| Component | Amount (g) |
|---|---|
| Naphthoquinone-1,2-diazido(2)-5-sulfonate of acetone/pyrogallol resin (synthesized by a method disclosed in Example 1 of US-A-3,635,709) | 5 |
| t-Butylphenol/formaldehyde resin (PS-50530; available from Sumitomo Jurays Co., Ltd.) | 0.5 |
| Cresol/formaldehyde resin (Hitanol #3110; available from Hitachi Chemical Co., Ltd.) | 5 |
| Methyl ethyl ketone | 50 |
| Cyclohexanone | 40 |

The PS plate thus obtained was exposed, for 30 seconds, to light from a 3 KW metal halide lamp (PLANO PS LIGHT provided with a light source: Toshiba Metal Halide Lamp MU 2000-2-0L type; available from Fuji Photo Film Co., Ltd.) in a distance of 1m within a vacuum printing frame.

Then, developers A to G listed in Table I were prepared and the viscosity thereof was determined by using a B-type viscometer.

Then, an automatic developing machine of the horizontally conveying type, equipped with a wire bar as a dispensing means, disclosed in JP-A- 62-59957, was provided. Each developer A to G was applied to the surface of the exposed PS plate whose light-sensitive layer was disposed upward in an amount of about 200 ml per 1 m$^2$ of the plate. After 40 seconds, the developer on the PS plate was squeezed out with a pair of squeeze rolls. The plate was then washed in a subsequent water washing bath and the plate was examined whether there was uneven development or not. The results observed are summarized in Table I. The developer A could not be uniformly held on the surface of the plate and the portions at which the thickness of the developer was thin could not be completely developed.

When the developer G was used, it could be uniformly held on the plate, but some contaminated developer was rarely adhered to the squeeze rolls, which was sometimes transferred to the plates subsequently treated.

When the developers B to F were used, good results were obtained in every case.

Table I

| Ex. No. | C.E.1 | Ex. 1 | Ex. 2 | Ex. 3 | Ex. 4 | Ex. 5 | Ex. 6 |
|---|---|---|---|---|---|---|---|
| Developer | A | B | C | D | E | F | G |
| Component of developer (g) | | | | | | | |
| Methyl cellulose *) | 0 | 14 | 25 | 50 | 75 | 90 | 100 |
| 1K Potassium silicate | 55 | 55 | 55 | 55 | 55 | 55 | 55 |
| 48 wt% aq. soln. of potassium hydroxide | 25 | 25 | 25 | 25 | 25 | 25 | 25 |
| Water | 950 | 950 | 950 | 950 | 950 | 950 | 950 |
| Viscosity (Pa·s) | 0.0028 | 0.008 | 0.02 | 0.15 | 1.05 | 4 | 9 |
| (cps) | 2.8 | 8 | 20 | 150 | 1,050 | 4,000 | 9,000 |
| Development | + | - | - | - | - | - | - |

*) Available from Shin-Etsu Chemical Co., Ltd. under the trade name of METOLOSE 65SH50.

Estimation criteria of "Development":

+ : uneven

- : even

Examples 7 to 12

A double side type PS plate was prepared by treating both sides of an aluminum plate and applying light-sensitive layers as in Examples 1 to 6, Both sides of the PS plate were imagewise exposed to light as in Examples 1 to 6.

Then a horizontally conveying type automatic developing machine of the disposable developing system as disclosed in Example 1 of JP-A-62-59958 and 8ℓ of a rinse solution having the following formulation which had been diluted 8 times was charged into the second bath thereof.

Formulation of the Rinse Solution

| | |
|---|---|
| 85 wt% Aqueous solution of phosphoric acid | 48 g |
| Sodium hydroxide | 19.2 g |
| Sodium dioctylsulfosuccinate | 24 g |
| Sodium dodecyl diphenyl ether disulfonate | 24 g |
| Silicone antifoaming agent TSA-731 | 0.08 g |
| Water | 875 g |

The double side type PS plate was developed with the developers A to G prepared above in the automatic developing machine. The results obtained are summarized in Table II. The developability of the upper face thereof with respect to these developer was completely the same as those observed in Examples 1 to 6.

When the developer A is applied to the back face of the plate, the developer dropped from the plate and many parts thereof could not developed. When the developer B was used, satisfactory development was observed although a part of the developer dropped.

The developers C to G were uniformly held on the back face of the plate and provided quite satisfactory results. In this respect, when the developer G was used, there was observed that contaminates were transferred to the squeeze rolls as in Example 6.

Table II

| Ex. No. | C.E.2 | Ex. 7 | Ex. 8 | Ex. 9 | Ex.10 | Ex.11 | Ex.12 |
|---|---|---|---|---|---|---|---|
| Developer | A | B | C | D | E | F | G |
| Viscosity (Pa·s) | 0.0028 | 0.008 | 0.02 | 0.15 | 1.05 | 4 | 9 |
| (cps) | 2.8 | 8 | 20 | 150 | 1,050 | 4,000 | 9,000 |
| Development of upper face | + | – | – | – | – | – | – |
| Uniformity of developer on back face | x | zy | zy | z | z | z | z |

The estimation criteria of an uneven development are the same as those described above in connection with Table I.

Those of "Uniformity of developer on back face" are as follows:

x : bad

y : permissible

z : good

**Claims**

1. A method for preparing a lithographic printing plate which comprises:
   (a) developing an imagewise light-exposed presensitized plate comprising a metal substrate having light-sensitive layers on both surfaces of the substrate, by simultaneously applying a fresh aqueous alkaline developer to each surface of the imagewise exposed light-sensitive layer while horizontally conveying the presensitized plate, maintaining the applied developer in a time period sufficient to remove either the light-exposed or the light-unexposed areas of the light-sensitive layer, and
   (b) removing the applied developer, and disposing the removed developer which is not reused, wherein the developer applied to both surfaces of the light-sensitive layers has a viscosity in the range of from 0,005 to 10 Pa.s (5 to 10,000 cps) at 25°C.

2. The method of claim 1 wherein the system for development is a disposable development system.

3. The method of claim 1 wherein the viscosity of the developer ranges from 0,05 to 5 Pa.s (50 to 5,000 cps).

4. The method of claim 1 wherein the viscosity of the developer is adjusted by the addition of at least one thickener.

5. The method of claim 1 wherein the developer comprises surfactants, organic solvents, alkali agents, inorganic salts and thickeners.

6. The method of claim 4 wherein the thickener is at least one water-soluble polymeric compound or fine powder of silicate.

7. The method of claim 6 wherein the thickener is at least one natural or synthetic water-soluble polymer.

8. The method of claim 7 wherein the thickener is at least one natural polymer and is selected from the group consisting of sweet potato starch, potato starch, tapioca starch, wheat starch and corn starch; carrageenan, laminaran, seaweed mannan, funorin, Irish moss, agar and sodium alginate; tororo-aoi mucin, mannan, quince seed gum, pectin, tragacanth gum, karaya gum, guar bean gum, locust bean gum, arabic gum, carob gum and benzoin gum; dextran, glucan and levan; succinoglucan and xanthan gum; glue, gelatin, casein and collagen.

9. The method of claim 7 wherein the thickener is at least one seminatural water-soluble polymer and is selected from the group consisting of propylene glycol alginate, viscose, methyl cellulose, ethyl cellulose, methyl ethyl cellulose, hydroxyethyl cellulose, carboxymethyl cellulose, hydroxypropyl cellulose, hydroxypropyl methyl cellulose, hydroxypropyl ethyl cellulose and hydroxypropyl methyl cellulose and processed starches.

10. The method of claim 9 wherein the processed starch is selected from white dextrin, yellow dextrin and British gum; enzyme dextrin and Shardinger enzyme dextrin; soluble starch; dialdehyde starch; modified alpha starch and non-modified alpha starch; phosphate starch, fatty acid starch, sulfate starch, nitrate starch, xanthogenic acid starch and carbamic acid starch; carboxyalkyl starch, hydroxyalkyl starch, sulfoalkyl starch, cyanoethyl starch, allyl starch, benzyl starch, carbamyl starch and dialkylamino starch; methylol cross-linked starch, hydroxyalkyl cross-linked starch, phosphoric acid cross-linked starch and dicarboxylic acid cross-linked starch; starch polyacrylamide copolymer, starch polyacrylic acid copolymer, starch polyvinyl acetate copolymer, starch polyacrylonitrile copolymer, cationic starch polyaycrylate copolymer, cationic starch vinyl polymer copolymer, starch polystyrene maleic acid copolymer and starch polyethylene oxide copolymer.

11. The method of claim 7 wherein the thickener is at least one synthetic water-soluble polymer and is selected from polyvinyl alcohol, polyvinyl alcohol partially modified with acetal, allyl modified polyvinyl alcohol, polyvinyl methyl ether, polyvinyl ethyl ester and polyvinyl isobutyl ether; sodium polyacrylate, partially saponified polyacrylate, partially saponified polyacrylate copolymer, polymethacrylic acid salts and polyacrylamide; polyethylene glycol, polyvinylpyrrolidone, copolymer of polyvinyl pyrrolidone and vinyl acetate, carboxyvinyl polymer, styrene-maleic anhydride copolymer, styrene-crotonic acid copolymer, polystyrene sulfonic acid salts and polymer of 2-acrylamido-2-methylpropane sulfonic acid, copolymers thereof with other monomers or salts thereof.

12. The method of claim 7 wherein the thickener is a semisynthetic and/or synthetic polymer.

13. The method of claim 4 wherein the amount of the thickener ranges from 0.5 to 20% by weight on the basis of the total weight of the developer.

14. The method of claim 1 wherein the pH of the developer at 25°C is not less than about 10.5.

15. The method of claim 1 wherein the developer comprises silicates and the amount thereof ranges from 1 to 8% by weight on the basis of the total weight of the developer.

16. The method of claim 15 wherein the silicate is represented by the formula: $SiO_2 . MO_2$ (wherein M is an alkali metal) and the molar ratio of $SiO_2/MO_2$ is not more than 1.2.

17. The method of claim 5 wherein the surfactant is selected from fluorine type ones having perfluoroalkyl groups in the molecule.

18. The method of claim 17 wherein the fluorine type surfactant having perfluoroalkyl groups in the molecule is selected from the group consisting of perfluoroalkylcarboxylic acid salts, perfluoroalkylsulfonic acid salts or perfluoroalkyl phosphoric acid salts; perfluoroalkyl betaine; perfluoroalkyl trimethylammonium salts; perfluoroalkylamine oxides, perfluoroalkyl ethylene oxide adducts, oligomers containing perfluoroalkyl groups and hydrophilic groups, oligomers having perfluoroalkyl groups and oleophilic groups, oligomers having perfluoroalkyl, hydrophilic and oleophilic groups or urethanes having perfluoroalkyl groups and oleophilic groups.

19. The method of claim 5 wherein the amount of the surfactant ranges from 0.001 to 3% by weight on the basis of the total weight of the developer.

**Patentansprüche**

1. Verfahren zum Herstellen einer lithographischen Druckplatte, welches umfaßt:
   (a) Entwickeln einer bildweise belichteten vorsensibilisierten Platte umfassend ein Metallsubstrat mit lichtempfindlichen Schichten auf beiden Oberflächen des Substrats, durch gleichzeitiges Auftragen eines frischen wäßrigen alkalischen Entwicklers auf jede Oberfläche der bildweise belichteten lichtempfindlichen Schicht, während die vorsensibilisierte Platte horizontal transportiert wird, Beibehalten des aufgetragenen Entwicklers in einem Zeitraum, der ausreichend ist, um entweder die belichteten oder die unbelichteten Stellen der lichtempfindlichen Schicht zu entfernen, und
   (b) Entfernen des aufgetragenen Entwicklers und Beseitigen des entfernten Entwicklers, der nicht wiederverwendet wird,
   worin der auf beide Oberflächen der lichtempfindlichen Schichten aufgetragene Entwickler eine Viskosität im Bereich von 0,005 bis 10 Pa.s (5 bis 10.000 cps) bei 25°C hat.

2. Verfahren nach Anspruch 1, worin das System zur Entwicklung ein Einwegentwicklungssystem ist.

3. Verfahren nach Anspruch 1, worin die Viskosität des Entwicklers im Bereich von 0,05 bis 5 Pa.s (50 bis 5.000 cps) liegt.

4. Verfahren nach Anspruch 1, worin die Viskosität des Entwicklers durch die Zugabe von mindestens einem Verdickungsmittel eingestellt wird.

5. Verfahren nach Anspruch 1, worin der Entwickler oberflächenaktive Mittel, organische Lösungsmittel, alkalische Mittel, anorganische Salze und Verdickungsmittel umfaßt.

6. Verfahren nach Anspruch 4, worin das Verdickungsmittel mindestens eine wasserlösliche Polymerverbindung oder ein feines Silicatpulver ist.

7. Verfahren nach Anspruch 6, worin das Verdickungsmittel mindestens ein natürliches oder synthetisches wasserlösliches Polymer ist.

8. Verfahren nach Anspruch 7, worin das Verdickungsmittel mindestens ein natürliches Polymer ist und gewählt wird aus der Gruppe bestehend aus Süßkartoffelstärke, Kartoffelstärke, Tapiocastärke, Weizenstärke und Maisstärke; Carrageen, Laminaran, Meerespflanzen-Mannan, Funorin, Irischem Moos, Agar und Natriumalginat; Tororo-aoi-Mucin, Mannan, Quittensamengummi, Pectin, Tragantgummi, Karaya-Gummi, Guarbohnengummi, Johannisbrotgummi (locust bean gum,), Gummi arabicum, Carobingummi (Johannisbrotgummi, carob gum) und Benzoingummi; Dextran, Glucan und Lävan; Succinoglucan und Xanthanlösung; Leim, Gelatine, Casein und Collagen.

9. Verfahren nach Anspruch 7, worin das Verdickungsmittel mindestens ein halbnatürliches wasserlösliches Polymer ist und gewählt wird aus der Gruppe bestehend aus Propylenglycolalginat, Viscose, Methylcellulose, Ethylcellulose, Methylethylcellulose, Hydroxyethylcellulose, Carboxymethylcellulose, Hydroxypropylcellulose, Hydroxypropylmethylcellulose, Hydroxypropylethylcellulose und Hydroxypropylmethylcellulose und verarbeiteten Stärken.

10. Verfahren nach Anspruch 9, worin die verarbeitete Stärke gewählt wird aus weißem Dextrin, gelbem Dextrin und Britischgummi; Enzymdextrin und Shardinger-Enzymdextrin; löslicher Stärke; Dialdehydstärke; modifizierter Alphastärke und nichtmodifizierter Alphastärke; Phosphatstärke, Fettsäurestärke, Sulfatstärke, Nitratstärke, Xanthogensäurestärke und Carbaminsäurestärke; Carboxyalkylstärke, Hydroxyalkylstärke, Sulfoalkylstärke, Cyanoethylstärke, Allylstärke, Benzylstärke, Carbamylstärke und Dialkylaminostärke; Methylol-vernetzter Stärke, Hydroxyalkyl-vernetzter Stärke, Phosphorsäurevernetzter Stärke und Dicarbonsäure-vernetzter Stärke; Stärke-Polyacrylamid-Copolymer, Stärke-Polyacrylsäure-Copolymer, Stärke-Polyvinylacetat-Copolymer, Stärke-Polyacrylnitril-Copolymer, kationische Stärke-Polyacrylat-Copolymer, kationische Stärke-Vinylpolymer-Copolymer, Stärke-Polystyrol-Maleinsäure-Copolymer und Stärke-Polyethylenoxid-Copolymer.

11. Verfahren nach Anspruch 7, worin das Verdickungsmittel mindestens ein synthetisches wasserlösliches Polymer ist und gewählt wird aus Polyvinylalkohol, Polyvinylalkohol, der teilweise mit Acetal modifiziert ist, Allylmodifiziertem Polyvinylalkohol, Polyvinylmethylether, Polyvinylethylester und Polyvinylisobutylether; Natriumpolyacrylat, teilweise verseiftem Polyacrylat, teilweise verseiftem Polyacrylatcopolymer, Polymethacrylsäuresalzen und Polyacrylamid; Polyethylenglycol, Polyvinylpyrrolidon, Copolymer aus Polyvinylpyrrolidon und Vinylacetat, Carboxyvinylpolymer, Styrol-Maleinsäureanhydrid-Copolymer, Styrol-Crotonsäure-Copolymer, Polystyrolsulfonsäuresalzen und Polymer von 2-Acrylamido-2-methylpropansulfonsäure, Copolymeren davon mit anderen Monomeren oder Salzen davon.

12. Verfahren nach Anspruch 7, worin das Verdickungsmittel ein halbsynthetisches und/oder synthetisches Polymer ist.

13. Verfahren nach Anspruch 4, worin die Menge des Verdickungsmittels im Bereich von 0,5 bis 20 Gew.-%, bezogen auf das Gesamtgewicht des Entwicklers, liegt.

14. Verfahren nach Anspruch 1, worin der pH des Entwicklers bei 25°C nicht weniger als etwa 10,5 ist.

15. Verfahren nach Anspruch 1, worin der Entwickler Silicate umfaßt und deren Menge im Bereich von 1 bis 8 Gew.-%, bezogen auf das Gesamtgewicht des Entwicklers, liegt.

16. Verfahren nach Anspruch 15, worin das Silicat durch die Formel $SiO_2 . MO_2$ dargestellt wird (worin M ein Alkalimetall ist) und das Molverhältnis von $SiO_2/MO_2$ nicht mehr als 1,2 beträgt.

17. Verfahren nach Anspruch 5, worin das oberflächenaktive Mittel gewählt wird aus oberflächenaktiven Mitteln vom Fluortyp mit Perfluoralkylgruppen im Molekül.

18. Verfahren nach Anspruch 17, worin das oberflächenaktive Mittel vom Fluortyp mit Perfluoralkylgruppen im Molekül gewählt wird aus der Gruppe bestehend aus Perfluoralkylcarbonsäuresalzen, Perfluoralkylsulfonsäuresalzen oder Perfluoralkylphosphorsäuresalzen; Perfluoralkylbetain; Perfluoralkyltrimethylammoniumsalzen; Perfluoralkylaminoxiden, Perfluoralkylethylenoxidaddukten, Oligomeren, die Perfluoralkylgruppen und hydrophile Gruppen enthalten, Oligomeren mit

13

Perfluoralkylgruppen und oleophilen Gruppen, Oligomeren mit Perfluoralkyl-, hydrophilen und oleophilen Gruppen oder Urethanen mit Perfluoralkylgruppen und oleophilen Gruppen.

**19.** Verfahren nach Anspruch 5, worin die Menge des oberflächenaktiven Mittels im Bereich von 0,001 bis 3 Gew.-%, bezogen auf das Gesamtgewicht des Entwicklers, liegt.

**Revendications**

**1.** Procédé de préparation d'une plaque d'impression lithographique qui comprend les étapes consistant à :
(a) développer une plaque présensibilisée exposée à la lumière selon une image constituée d'un substrat métallique comportant des couches photosensibles sur les deux surfaces du substrat, en appliquant simultanément un révélateur en solution aqueuse alcaline frais sur chaque surface de la couche photosensible exposée selon une image, tout en déplaçant horizontalement la plaque présensibilisée, en maintenant le révélateur appliqué en une période suffisante pour éliminer soit les zones exposées à la lumière, soit les zones non exposées à la lumière de la couche photosensible, et
(b) retirer le révélateur appliqué et jeter le révélateur retiré, qui n'est pas réutilisé, dans lequel le révélateur appliqué sur les deux surfaces des couches photo-sensibles a une viscosité qui est située dans l'intervalle de 0,005 à 10 Pa.s (5 à 10 000 cP) à 25°C.

**2.** Procédé selon la revendication 1, dans lequel le système de développement est un système de développement jetable.

**3.** Procédé selon la revendication 1, dans lequel la viscosité du révélateur est située dans l'intervalle de 0,05 à 5 Pa.s (50 à 5 000 cP).

**4.** Procédé selon la revendication 1, dans lequel la viscosité du révélateur est ajustée au moyen de l'addition d'au moins un épaississant.

**5.** Procédé selon la revendication 1, dans lequel le révélateur comprend des tensioactifs, des solvants organiques, des agents alcalins, des sels inorganiques et des épaississants.

**6.** Procédé selon la revendication 4, dans lequel l'épaississant est au moins un composé polymérique hydrosoluble ou une fine poudre de silicate.

**7.** Procédé selon la revendication 6, dans lequel l'épaississant est au moins un polymère hydrosoluble naturel ou synthétique.

**8.** Procédé selon la revendication 7, dans lequel l'épaississant est au moins un polymère naturel et est choisi dans le groupe constitué de : amidon de pomme de terre douce, amidon de pomme de terre, amidon de tapioca, amidon de froment et amidon de maïs ; carraghénate, laminarane, mannane de crin végétal, funori, carragheen, gomme d'agar et alginate de sodium ; mucine de type tororo-aoi, mannane, gomme de grain de coing, pectine, gomme de tragacanthe, comme de karaya, gomme de guar, gomme de graine de caroubier, gomme arabique, gomme de caroube et benjoin ; dextrane, glucane et levane ; succinoglucane et gomme de xanthane ; colle, gélatine, caséine et collagène.

**9.** Procédé selon la revendication 7, dans lequel l'épaississant est au moins un polymère semi-naturel hydrosoluble et est choisi dans le groupe constitué des suivants : alginate de propylèneglycol, viscose, méthylcellulose, éthylcellulose, méthyléthylcellulose, hydroxyéthylcellulose, carboxyméthylcellulose, hydroxypropylcellulose, hydroxypropyléthylcellulose et hydroxypropylméthylcellulose ainsi que des amidons traités.

**10.** Procédé selon la revendication 9, dans lequel l'amidon traité est choisi parmi les suivants : dextrine blanche, dextrine jaune et dextrine commerciale, dextrine enzymatique et dextrine enzymatique de Shardinger ; amidon soluble ; amidon dialdéhydique ; amidon $\alpha$ modifié et non modifié; amidon phosphaté ; amidon d'acide gras ; amidon sulfaté; amidon nitré; amidon d'acide xanthogénique et amidon d'acide carbamique ; amidon carboxyalkylique, amidon hydroxyalkylique, amidon sulfoalkylique, amidon cyanoéthylique, amidon allylique, amidon benzylique, amidon carbamylique et amidon dialkylaminé; amidon réticulé par des groupements méthylol, amidon réticulé par des groupements hydroxyalkyle, amidon réticulé par de l'acide phosphorique et amidon réticulé par de l'acide dicarboxylique ; copolymère amidon-polyacrylamide, copolymère amidon poly(acide acrylique), copolymère amidon poly(acétate de vinyle), copolymère amidon polyacrylonitrile, copolymère amidon cationique polyacrylate, copolymère amidon cationique polymère vinylique, copolymère amidon polystyrène acide maléique et copolymère amidon poly(oxyde d'éthylène).

11. Procédé selon la revendication 7, dans lequel l'épaississant est au moins un polymère synthétique hydrosoluble et est choisi parmi les suivants: poly(alcool vinylique), poly(alcool vinylique) partiellement modifié par des acétals, poly(alcool vinylique) modifié par des groupements allyle, poly(éther vinylique de méthyle), poly(ester vinylique d'éthyle) et poly(éther vinylique d'isobutyle) ; polyacrylate de sodium, polyacrylate partiellement saponifié, copolymère de polyacrylate partiellement saponifié, sels de poly(acide méthacrylique) et polyacrylamide ; polyéthylèneglycol, polyvinylpyrrolidone, copolymère de polyvinylpyrrolidone et d'acétate de vinyle, polymère carboxyvinylique, copolymère styrène-anhydride maléique, copolymère styrène-acide crotonique, sels de poly(acide styrènesulfonique) et polymère d'acide 2-acrylamido-2-méthylpropanesulfonique, copolymères de ceux-ci avec d'autres monomères ou sels de ceux-ci.

12. Procédé selon la revendication 7, dans lequel l'épaississant est un polymère semi-synthétique et/ou synthétique.

13. Procédé selon la revendication 4, dans lequel la quantité d'épaississant se situe entre 0,5 et 20 % en masse par rapport à la masse totale de révélateur.

14. Procédé selon la revendication 1, dans lequel le pH du révélateur à 25°C est supérieur ou égal à 10,5.

15. Procédé selon la revendication 1, dans lequel le révélateur comprend des silicates et la quantité de ceux-ci se situe dans l'intervalle de 1 à 8 % en masse par rapport à la masse totale de révélateur.

16. Procédé selon la revendication 15, dans lequel le silicate est représenté par la formule : $SiO_2 . MO_2$ (dans laquelle M représente un métal alcalin) et le rapport molaire $SiO_2/MO_2$ est inférieur ou égal à 1,2.

17. Procédé selon la revendication 5, dans lequel le tensioactif est choisi parmi les tensioactifs de type fluoré comportant des groupements perfluoroalkyle dans leur molécule.

18. Procédé selon la revendication 17, dans lequel le tensioactif de type fluoré possédant des groupements peffluoralkyle dans sa molécule est choisi parmi les suivants : sels d'acides perfluoroalkylcarboxyliques, sels d'acides perfluoroalkylsulfoniques ou sels d'acides perfluoroalkylphosphoriques ; perfluoroalkylbétaine ; sels de perfluoroalkyltriméthylammonium, oxydes de perfluoroalkylamine, produits d'addition d'oxyde d'éthylène et de perfluoroalkyle, oligomères contenant des groupements perfluoroalkyle et des groupements hydrophiles, oligomères comportant des groupements perfluoroalkyle et des groupements oléophiles, oligomères comportant des groupements perfluoroalkyle, des groupements hydrophiles et des groupements oléophiles ou uréthannes comportant des groupements perfluoroalkyle et des groupements oléophiles.

19. Procédé selon la revendication 5, dans lequel la quantité de tensioactif se situe dans l'intervalle de 0,001 à 3 % en masse par rapport à la masse totale de révélateur.